# EUROPEAN PATENT SPECIFICATION

(11) **EP 3 251 477 B1**
(45) Date of publication and mention of the grant of the patent: **09.12.2020**
(21) Application number: 15880564.8
(22) Date of filing: 31.01.2015
(51) Int. Cl.: H05K 7/20, G06F 1/20

(54) **MEMORY COOLING PAD**
KÜHLPAD FÜR SPEICHER
TAMPON DE REFROIDISSEMENT DE MÉMOIRE

(43) Date of publication of application: 06.12.2017
(73) Proprietor: Hewlett Packard Enterprise Development LP, Houston, TX 77070 (US)
(72) Inventor: FRANZ, John P., Houston, Texas 77070 (US); BOWDEN, Thomas R., Houston, Texas 77070 (US); BARGERHUFF, Richard A., Houston, Texas 77070 (US); ZIMMERMAN SR., Sammy L., Houston, Texas 77070 (US); CADER, Tahir, Liberty Lake, Washington 99019 (US)
(74) Representative: Iqbal, Md Mash-Hud
(86) International application number: PCT/US2015/014007
(87) International publication number: WO 2016/122674

(56) References cited:
- JP-A- 2006 339 325
- KR-B1- 100 506 087
- US-A1- 2002 159 237
- US-A1- 2005 018 401
- US-A1- 2008 116 571
- US-A1- 2008 192 428
- US-A1- 2009 303 681

## Description

### Background

Cooling dual in line memory modules (DIMM) within a server can include utilizing an aluminum jacket on each DIMM. The aluminum jackets can be held together utilizing stainless brackets that are coupled to each DIMM. The aluminum jackets can be utilized in a manner that includes a vapor chamber that is on a top portion of the DIMM (e.g., opposite end of DIMM pins). The aluminum jackets may have to be customized for individual DIMM types, which can increase cost of end products. In addition, the aluminum jackets may need to be tested and have a manufacturer warranty since the aluminum jackets may not be easily removed and may be configured for a particular DIMM and/or memory type.

The aluminum jacket can include a thermal interface junction on a top of the aluminum jacket. For example, the aluminum jacket can include a vapor chamber that rests on the top portion of the aluminum jacket. Heat from the DIMM can be transferred to the aluminum jacket via a thermal interface material and transferred to a heat exchange unit via the thermal interface junction.

US2009/0303681 discloses a coined-sheet-metal heatsink.

US2002/0159237 discloses a cooling arrangement.

US2005/0018401 discloses a device for cooling memory modules.

### Brief Description of the Drawings

Figure 1 illustrates a diagram of an example of a DIMM cooling system consistent with the present disclosure.
Figure 2 illustrates a diagram of an example of a memory cooling pad consistent with the present disclosure.
Figure 3 illustrates a diagram of an example of a memory cooling pad consistent with the present disclosure.
Figure 4 illustrates a diagram of an example of a memory cooling pad system consistent with the present disclosure.
Figure 5 illustrates a diagram of an example of a memory cooling pad system consistent with the present disclosure.

### Detailed Description

The memory cooling pad of the present invention according to claim 1 can provide additional cooling performance with a relatively lower cost compared to previous systems and methods of DIMM cooling. The memory cooling pad includes a first thermal interface material coupled to a second thermal interface material by a liner material configured to position the first thermal interface material on a first side of a memory unit (e.g., DIMM, etc.) and to position the second thermal interface material on a second side of the memory unit.

The liner material is a relatively thin polymer material such that the memory cooling pad can be folded around a memory unit such that the first thermal interface material is on a first side of the memory unit and the second thermal interface material is on a second side of the memory unit. The liner material provides a thermal interface for two sides of a DIMM with relatively easy installation that can also be more easily removed if needed without damaging the DIMM with adhesives. In some examples, the thermal interface material can include a gap pad type of material, among other thermal interface materials that can be coupled to the liner material. The thermal interface materials can comprise materials that electrically insulate and thermally conduct. The liner material is a relatively thin polymer material (e.g. plastic, etc.) that can be permanently attached to the first thermal interface material and the second thermal interface material. That is, the liner material would be permanently attached to the thermal interface materials after installation of the memory cooling pad on a DIMM. The liner material can be permanently attached to the thermal interface materials.

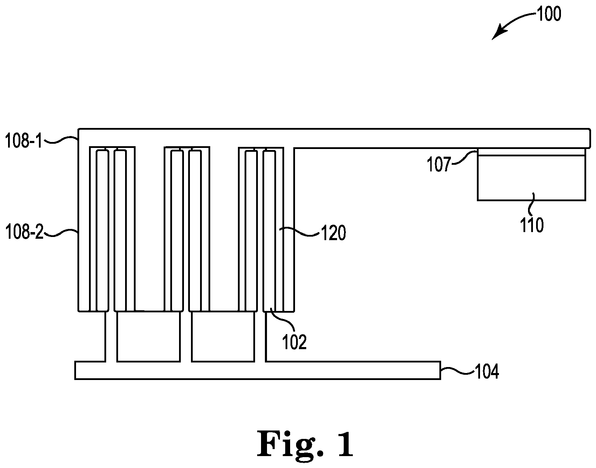

Figure 1 illustrates a diagram of an example of a DIMM cooling system 100 consistent with the present disclosure. The DIMM cooling system 100 can utilize a cooling plate 108-1 that comprises a number of combs 108-2 that can be positioned between a number of DIMM devices 102. The DIMM cooling system 100 can utilize a memory cooling pad 120 that surrounds and/or encompasses the DIMM device 102.

The system 100 can include a cooling plate 108-1 comprising an interior portion and a comb portion 108-2. The comb portion 108-2 can include extrusion tips (e.g., aluminum extrusion tips, etc.) coupled to the cooling plate 108-1. The cooling plate 108-1 and the comb portion 108-2 could be comprised of one or more of the following: combination of high performance conductive solutions (heat pipes), coolant flowing through the cooling plate 108-1 and comb portion 108-2 and returning to a cooling unit 110, among other cooling techniques. Liquid (e.g., water, coolant, etc.) can flow through the interior of the comb portions 108-2 to cool the DIMM device 102.

Heat from the DIMM device 102 can be transferred to the comb portion 108-2 and/or be absorbed by liquid within the comb portion 108-2. The heat from the DIMM device 102 can be transferred to the cooling plate 108-1 and flow to a cooling unit 110. In some examples, a thermal interface junction 107 can be utilized to transfer heat from the cooling plate 108-1 to the cooling unit 110. For example, the heat from the comb portion 108-2 can flow to the cooling plate 108-1 to a remote cooling unit 110. In some examples, liquid can flow through the cooling plate 108-1 and through the comb portion 108-2 and back to a cooling unit 110 to remove heat from the DIMM device 102. The cooling plate 108-1 can be removed from the DIMM device 102 when not in use and/or when removing the DIMM device 102 from the computing device 204.

In some examples, the cooling plate 108-1 can be replaced with a different heat exchange unit such as: a solid conductive material (e.g., aluminum, graphite, copper, etc.), a high performance conductive solution such as a vapor chamber or a coolant chamber, and/or a continually flowing liquid coolant system. In these examples, the cooling unit 110 can be utilized to cool the heat exchange unit 108 and/or to remove heat from the DIMM device 102.

The system 100 can utilize the memory cooling pad 120 and remove a thermal interface junction that exists in previous systems and methods (e.g., thermal interface junction between an aluminum jacket and a heat exchange unit). By removing thermal interface junctions, the system 100 can transfer heat from the DIMM 102 more effectively compared to previous systems and methods. In addition, as described further herein, the memory cooling pad 120 can be advantageous over the aluminum jacket.

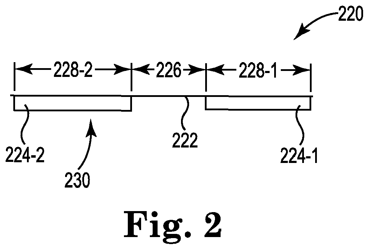

Figure 2 illustrates a diagram of an example of a memory cooling pad 220 consistent with the present disclosure. The memory cooling pad 220 can be positioned in a linear fashion. The memory cooling pad 220 can include a liner material 222. The liner material 222 can comprise a polymer type material (e.g., plastic material). The liner material 222 can extend continuously (e.g., without a separation, etc.) from a first end of the memory cooling pad 220 to a second end of the memory cooling pad 220. The memory cooling pad 220 can be utilized in system 100 as referenced in Figure 1.

The liner material 222 can be permanently attached to a first thermal interface material 224-1 on a first end of the memory cooling pad 220 and permanently attached to a second thermal interface material 224-2 at a second end of the memory cooling pad 220. The liner material 222 can include a polymer material that is permanently bonded to the thermal interface materials 224-1, 224-2. The liner material 222 can reinforce the thermal interface materials 224-1, 224-2 and prevent punctures and/or tears of the thermal interface material 224-1, 224-2. For example, the liner material 222 can be a relatively strong material that prevents an extrusion portion of the cooling plate from puncturing or tearing the softer thermal interface materials 224-1, 224-2. In some examples, the liner material 222 can extend across one side of the memory cooling pad 220 coupling a first thermal interface material 224-1 and a second thermal interface material 224-2. That is, first thermal interface material 224-1 and the second thermal interface material 224-2 comprise an exterior side coupled to the liner material 222 and an interior side not coupled to the liner material 222.

The thermal interface material 224-1, 224-2 can include a gap pad type of material, among other thermal interface materials that can be attached to the liner material 222. The thermal interface material 224-1, 224-2 can comprise a material that electrically insulates and thermally conducts. The thermal interface material 224-1, 224-2 can be a relatively conformable material that also has a relatively low hardness level. In some examples, the thermal interface material 224-1, 224-2 can include a material that has a relatively high elasticity (e.g., resilience, etc.). The elasticity can provide a height recovery after deformation (e.g., coupled to the DIMM). The elasticity can allow the thermal interface material 224-1, 224-2 to be removed from a first DIMM and regain an original shape. The thermal interface material 224-1, 224-2 can then be re-used for a second DIMM even when the second DIMM has a different shape than the first DIMM. That is, the thermal interface material 224-1, 224-2 can conform to the shape of a DIMM to provide a better thermal connection between the thermal interface material 224-1, 224-2 and the DIMM.

The memory cooling pad 220 can provide a thermal interface between two sides of a DIMM device and a cooling plate. For example, the thermal interface material 224-1 can act as a thermal interface for a first side of a DIMM and the thermal interface material 224-2 can act as a thermal interface for a second side of a DIMM. As described herein, the thermal interface material 224-1, 224-2 can be relatively conformable so that the thermal interface material 224-1, 224-2 can be conformed to the exterior shape of each side of the DIMM. For example, the thermal interface material 224-1 can conform to the exterior shape of the first side of a DIMM and the thermal interface material 224-2 can be conformable to the exterior shape of the second side of the DIMM. A thermal interface material 224-1, 224-2 that is conformable can be advantageous over previous systems and methods since the exterior shape and/or texture of different models of DIMMs can be different.

The thermal interface material 224-1, 224-2 can conform to the first side and second side of the DIMM respectively so the thermal interface material 224-1, 224-2 can have a greater connection for a larger surface area of the DIMM compared to previous systems and methods. That is, a greater portion of the thermal interface material 224-1, 224-2 can be in contact with the DIMM and/or a number of combs of the cooling plate by conforming to the shape of the DIMM and/or the number of combs of the cooling plate.

In some examples, the first thermal interface material 224-1 can have a length 228-1 of approximately 26 millimeters (e.g., 22 millimeters to 30 millimeters). In addition, the second thermal interface material 224-2 can have a length 228-2 of approximately 26 millimeters. The length 228-1 of the first thermal interface material 224-1 and the length 228-2 of the second thermal interface material 224-2 can be altered to accommodate different dimensions of DIMM units and/or other memory units.

In some examples, the first thermal interface material 224-1 and the second thermal interface material 224-2 can be approximately 1.5 millimeters thick (e.g., 1.4 millimeters to 1.6 millimeters). In other examples, the first thermal interface material 224-1 and the second thermal interface material 224-2 can be approximately 1.25 millimeters thick (e.g., 1.15 millimeters to 1.35 millimeters). The thickness of the first thermal interface material 224-1 and the second thermal interface material 224-2 can be configured to fit over the DIMM and between a number of combs coupled to a cooling plate as described herein.

In some examples there can be a space 226 between the first thermal interface material 224-1 and the second thermal interface material 224-2. The space 226 between the first thermal interface material 224-1 and the second thermal interface material 224-2 can be approximately 5 millimeters (e.g., 3 millimeters to 7 millimeters). The space 226 between the first thermal interface material 224-1 and the second thermal interface material 224-1 can include no thermal interface material or thermal interface. That is, the space 226 between the first thermal interface material 224-1 and the second thermal interface material 224-2 does not have a thermal interface material attached to the liner material 222. In some examples, only the liner material 222 is utilized within the space 226 between the first thermal interface material 224-1 and the second thermal interface material 224-2. In some examples, the space 226 a can be a portion of the thermal interface material that is removed from the liner material.

In some examples, the memory cooling pad 220 can include a tacky side 230. The tacky side 230 can be an opposite side from the liner material 222. The tacky side 230 of the memory cooling pad 220 and help create a relatively light adhesion between the memory cooling pad 220 and the DIMM. In some examples, the tacky side 230 does not include an additional adhesive material that can possibly damage the DIMM. That is, the tacky side 230 can be part of a gap pad interface material as described herein.

The memory cooling pad 220 can be folded over a DIMM that is coupled to a DIMM slot. The memory cooling pad 220 can be easily removed from the DIMM in cases where the DIMM needs to be replaced or removed from the DIMM slot. In addition, the memory cooling pad 220 can be utilized on a first DIMM and when the first DIMM needs to be replaced, the memory cooling pad 220 can be removed from the first DIMM and utilized for a second DIMM that replaces the first DIMM. Thus, the memory cooling pad 220 provides a relatively inexpensive, easily configurable, and interchangeable cooling pad for memory units such as DIMMs.

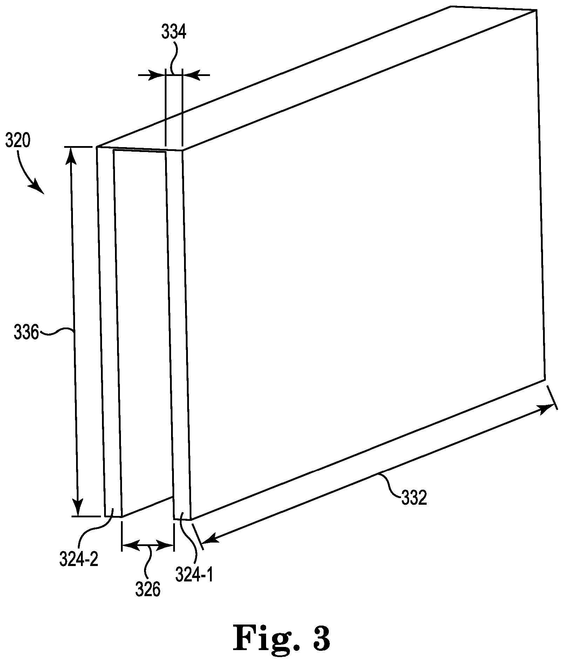

Figure 3 illustrates a diagram of an example of a memory cooling pad 320 consistent with the present disclosure. The memory cooling pad 320 can be an illustration of memory cooling pad 220 as referenced in Figure 2 in a folded position that can be wrapped on an exterior portion of a DIMM device. The memory cooling pad 320 can provide a thermal interface between two sides of a DIMM device and a cooling plate. The memory cooling pad 320 can be utilized in system 100 as referenced in Figure 1.

The memory cooling pad 320 can comprise a thermal interface material 324-1, 324-2 that is attached to a liner material 327. The thermal interface material 324-1, 324-2 can include a gap pad type of material, among other thermal interface materials that can be coupled to the liner material 327. The thermal interface material 324-1, 324-2 can comprise a material that electrically insulates and thermally conducts. The thermal interface material 324-1, 324-2 can be a relatively conformable material that also has a relatively low hardness level. That is, the thermal interface material 324-1, 324-2 can conform to the shape of a DIMM to provide a better thermal connection between the thermal interface material 324-1, 324-2 and the cooling plate.

When the memory cooling pad 320 is in the folded formation the space 326 between the first thermal interface material 324-1 and the second thermal interface material 324-2 can be approximately 4 millimeters (e.g., 3 millimeters to 5 millimeters). The space 326 can be altered for a number of different DIMM and/or DIMM slot configurations. That is, the space 326 can be configured for a particular DIMM size and/or DIMM slot configuration.

In some examples, the memory cooling pad 320 can include a tacky interior portion 330 that can couple the thermal interface materials 324-1, 324-2 of the memory cooling pad 320 to the DIMM. The tacky interior portion 330 can provide a light bond to the DIMM device without an adhesive material that can potentially cause damage to the DIMM.

The liner material 322 can be permanently attached to a first thermal interface material 324-1 on a first end of the memory cooling pad 320 and permanently attached to a second thermal interface material 324-2 at a second end of the memory cooling pad 320. The liner material 322 can include a polymer material that is permanently bonded to the thermal interface materials 324-1, 324-2. The liner material 322 can reinforce the thermal interface materials 324-1, 324-2 and prevent punctures and/or tears of the thermal interface material 324-1, 324-2. For example, the liner material 322 can be a relatively strong material that prevents an extrusion portion of the cooling plate from puncturing or tearing the softer thermal interface materials 324-1, 324-2. In some examples, the liner material 322 can extend across one side of the memory cooling pad 320 coupling a first thermal interface material 324-1 and a second thermal interface material 324-2.

The liner material 322 can act as a liner bridge over the top of the DIMM. The liner bridge can prevent damage to the DIMM when placing the comb portion of a cooling plate between a number of DIMMs installed on a computing device (e.g., motherboard, etc.). For example, the liner bridge over the top of the DIMM can direct an aluminum comb of the cooling plate between the DIMM and a different DIMM. In addition, the liner material 322 can prevent the thermal interface material 324-1, 324-2 from being removed from the DIMM by the aluminum comb of the cooling plate. That is, the liner bridge over the top of the DIMM can prevent the thermal interface material 324-1, 324-2 from be pushed out of position by the aluminum comb of the cooling plate.

The liner material 322 can also aid in the installation of the memory cooling pad 320 on to the DIMM. For example, the liner material 322 can help position the first thermal interface material 324-1 into a desired position on a first side of a DIMM. In this example, the length of the liner (e.g., sum of 228-1, 226, and 228-2 as referenced in Figure 2) can help position the second thermal interface material 324-2 when folding the memory cooling pad 320 to position the second thermal interface material 324-2 on a second side of the DIMM. That is, the length of the liner can be utilized to automatically position the second thermal interface material 324-2 in a desired position (e.g., thermal interface material 324-2 is placed over the DIMM such that the second side of the DIMM is completely covered by the second thermal interface material 324-2) when the first thermal interface material 324-1 is positioned in a desired position.

The first thermal interface material 324-1 and the second thermal interface material 324-2 can be positioned on a first side and a second side of the DIMM respectively. In some examples, there is no thermal interface material coupled to the liner material 322 at the space 330 corresponding to a top portion of the DIMM. That is, there is no thermal interface material at a top portion of the DIMM.

In some examples, the first thermal interface material 324-1 can have a length 336 of approximately 26 millimeters (e.g., 22 millimeters to 30 millimeters). In addition, the second thermal interface material 324-2 can have a length 336 of approximately 26 millimeters. The length 336 of the first thermal interface material 324-1 and the length 336 of the second thermal interface material 324-2 can be altered to accommodate different dimensions of DIMM units and/or other memory units.

In some examples, the first thermal interface material 324-1 and the second thermal interface material 324-2 can have a thickness 334 of approximately 1.5 millimeters (e.g., 1.4 millimeters to 1.6 millimeters). In other examples, the first thermal interface material 324-1 and the second thermal interface material 324-2 can have a thickness 334 of approximately 1.25 millimeters (e.g., 1.15 millimeters to 1.35 millimeters). The thickness 334 of the first thermal interface material 324-1 and the second thermal interface material 324-2 can be configured to fit over the DIMM and between a number of combs coupled to a cooling plate as described herein.

In some examples, the memory cooling pad 320 can have a width 332 of approximately 125 millimeters (e.g., 120 millimeters to 130 millimeters). The width 332 can be configured to fit a width of the DIMM and/or memory unit. For example, the width 332 can be configured to fit between a first end of a DIMM slot and a second end of the DIMM slot in order to cover a greater portion of the DIMM.

The memory cooling pad 320 can be folded over a DIMM that is coupled to a DIMM slot. The memory cooling pad 320 can be easily removed from the DIMM in cases where the DIMM needs to be replaced or removed from the DIMM slot. In addition, the memory cooling pad 320 can be utilized on a first DIMM and when the first DIMM needs to be replaced, the memory cooling pad 320 can be removed from the first DIMM and utilized for a second DIMM that replaces the first DIMM. Thus, the memory cooling pad 320 provides a relatively inexpensive, easily configurable, and interchangeable cooling pad for memory units such as DIMMs.

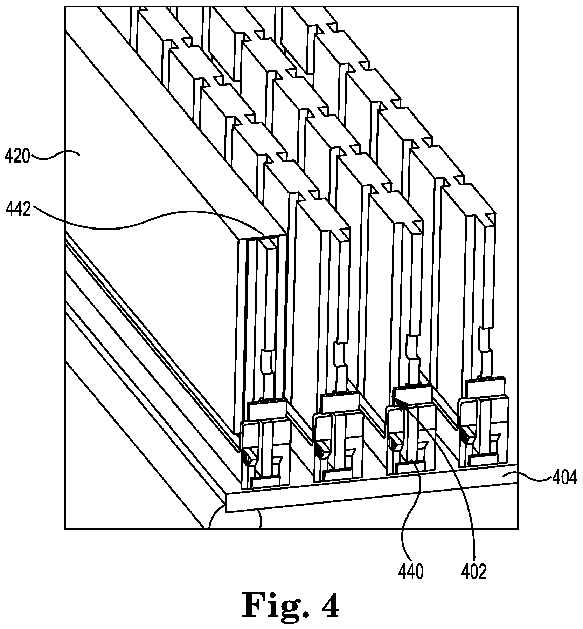

Figure 4 illustrates a diagram of an example of a memory cooling pad system 450 consistent with the present disclosure. The system 450 can include a number of DIMMs 402 coupled to a computing device 404 (e.g., motherboard, etc.). The number of DIMMs 402 can be coupled to the computing device 404 via a number of DIMM slots 440.

The system 450 can include a memory cooling pad 420 coupled to each of the number of DIMMs 402. As described herein, the memory cooling pad 402 can include a number of thermal interface materials coupled to a liner material as described in reference to Figure 2 and Figure 3. The memory cooling pad 420 can be coupled to the number of DIMMs 402 via a tacky side of the memory cooling pad 420. The tacky side of the memory cooling pad 420 can include a material on the thermal interface material that partially adheres to the DIMMs without a permanent or semi-permanent adhesive (e.g., glue, etc.).

The memory cooling pad 420 can be positioned such that a first thermal interface material is positioned on a first side of the DIMMs 402 and a second thermal interface material is positioned on a second side of the DIMMs 402. The thermal interface material can be positioned between a first side of a DIMM slot 440 and a second side of a DIMM slot 440 such that the thermal interface material covers a complete side of the DIMM 402 within the DIMM slot 440.

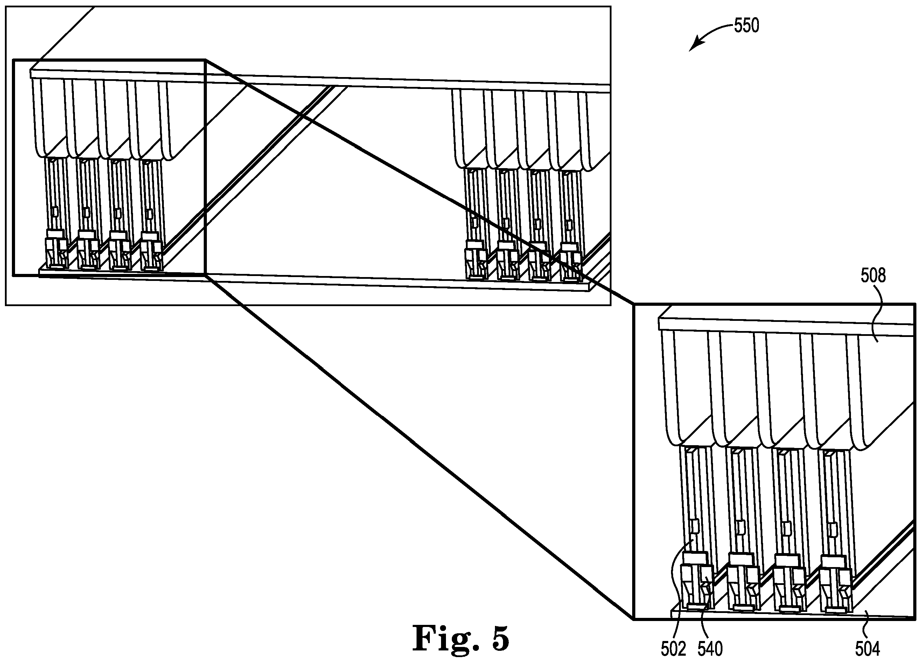

Figure 5 illustrates a diagram of an example of a memory cooling pad system 550 consistent with the present disclosure. The system 550 can include a number of memory cooling pads 520 that can be placed (e.g., coupled, wrapped around, etc.) on the number of DIMMs 502 that are coupled to a number of corresponding DIMM slots 540. The number of memory cooling pads 520 can positioned around each of the number of DIMMs 502 coupled to the number of corresponding DIMM slots 540 such that the thermal interface material of the memory cooling pads 520 are touching a first side and a second side of the number of DIMMs 502. That is, the memory cooing pads 520 are attached such that the thermal interface materials are touching the sides of the DIMMs 502.

As described herein, the memory cooling pads 520 can include a space that does not include a thermal interface material. The space can be a portion of the memory cooling pads 520 where only a liner material is utilized. The space can be positioned to a top portion of the number of DIMMs 502. The top portion of the number of DIMMs 502 can be a position that is opposite of the DIMM slot 540 that each of the number of DIMMs 502 are coupled. In some examples the liner material does not act as a thermal interface between the top of the DIMMs and the cooling plate 508-1.

The thermal interface material for each of the memory cooling pads 520 can include a conformable thermal interface material that is capable of conforming (e.g., molding to the shape) to the shape of a corresponding side of the DIMMS 502. That is, the thermal interface material that is coupled to the liner material of the memory cooling pads 520 can be conformed to the shape of the DIMM to create a better connection with more surface area between the thermal interface material and the DIMM. This conforming capability can provide for better thermal conduction between the cooling plate combs 508-2 and the DIMM 502.

The liner of the memory cooling pads 520 can prevent the cooling plate combs 508-2 from puncturing or tearing the thermal interface material. That is, the liner material can prevent puncturing or tearing of the thermal interface material of the memory cooling pads 520 when the cooling plate combs 508-2 are placed between the number of memory cooling pads 520 and DIMMs 502. As described herein, the cooling plate 508-1 can utilize a cooling system (e.g., liquid cooling system, air cooling system, other heat conducting methodology, etc.).

In some examples, the cooling system can operate by pushing liquid through an interior portion of the cooling plate combs 508-2. The cooling plate combs 508-2 can extract heat from the thermal interface material of the memory cooling pads 520. As described herein, the memory cooling pads 520 can include a conformable thermal interface material that can conform to the shape of the DIMMs 502 and utilize a greater quantity of surface area when conducting heat from the DIMMs 502 to the cooling plate combs 508-2 compared to previous systems and methods.

In some examples, the thermal interface materials of the memory cooling pad 520 (e.g., gap pad material, etc.) can be attached to the comb portion 508-2 of the cooling plate 508-1. That is, the thermal interface material can be permanently attached to each of the combs 508-2 of the cooling plate 508-1. The thermal interface material can be attached to each of the combs 508-2 via an adhesive material. In some examples, the thermal interface material can be attached to each of the combs 508-2 via an over-molded process. For example, the thermal interface material can be attached by injection molded around each of the combs 508-2. The thermal interface material can be attached to the combs 508-2 on the same side as the side attached to the liner material as described herein.

The memory cooling pad 520 can be folded over a DIMM 502 that is coupled to a DIMM slot 540. The memory cooling pad 520 can be easily removed from the DIMM 502 in cases where the DIMM 502 needs to be replaced or removed from the DIMM slot 540. In addition, the memory cooling pad 520 can be utilized on a first DIMM and when the first DIMM needs to be replaced, the memory cooling pad 520 can be removed from the first DIMM and utilized for a second DIMM that replaces the first DIMM. Thus, the memory cooling pad 520 provides a relatively inexpensive, easily configurable, and interchangeable cooling pad for memory units such as DIMMs 502.

## Claims

1. A memory cooling pad (120, 220, 320, 420), comprising:
a first thermal interface material (224-1, 324-1);
a second thermal interface material (224-2, 324-2); and
a liner material (222, 322) whereby the first thermal interface material (224-1, 324-1) is coupled to the second thermal interface material (224-2, 324-2) by the liner material (222, 322);
**characterised in that** the liner material (222, 322) is a relatively thin polymer material such that the memory cooling pad (120, 220, 320, 420) can be folded around a memory unit such that the first thermal interface material (224-1, 324-1) is on a first side of the memory unit and the second thermal interface material (224-2, 324-2) is on a second side of the memory unit

2. The memory cooling pad (120, 220, 320, 420) of claim 1, comprising a space between the first thermal interface material (224-1, 324-1) and the second thermal interface material (224-2, 324-2).

3. The memory cooling pad (120, 220, 320, 420) of claim 2, wherein the space is positioned between the first side of the memory unit and the second side of the memory unit.

4. The memory cooling pad (120, 220, 320, 420) of claim 3, wherein the liner material (222, 322) is different than the first thermal interface material (224-1, 324-1) and the second thermal interface material (224-2, 324-2).

5. The memory cooling pad (120, 220, 320, 420) of claim 3, wherein the space is between 4 millimeters and 6 millimeters.

6. The memory cooling pad (120, 220, 320, 420) of claim 3, wherein the space is configured to provide an non-interface area.

7. The memory cooling pad (120, 220, 320, 420) of claim 1, wherein the first thermal interface material (224-1, 324-1) and the second thermal interface material (224-2, 324-2) comprise an exterior side coupled to the liner material (222, 322) and an interior side not coupled to the liner material (222, 322).

8. The memory cooling pad (120, 220, 320, 420) of claim 7, wherein the interior side of the first thermal interface material (224-1, 324-1) and the second thermal interface material (224-2, 324-2) comprises a non-adhesive material.

9. The memory cooling pad (120, 220, 320, 420) of claim 2, wherein the space is an interface between the memory device and the cooling assembly.

10. The memory cooling pad (120, 220, 320, 420) of claim 1, wherein the first thermal interface material (224-1, 324-1) and the second thermal interface material (224-2, 324-2) are relatively conformable materials.

11. A system comprising the memory cooling pad (120, 220, 320, 420) of claim 1, further comprising:
a cooling assembly comprising comb structures, wherein the cooling pad is compressed by the comb structures of the cooling assembly positioned between the memory unit (120, 220, 320, 420) and a different memory unit.

12. The system of claim 1, wherein the first thermal interact material (224-1, 324-1) and the second thermal interface material (224-2, 324-2) comprise a material that is electrically insulating and thermally conductive.

## Patentansprüche

1. Speicher-Kühlpad (120, 220, 320, 420), das Folgendes umfasst:
ein erstes thermisches Grenzflächenmaterial (224-1, 324-1);
ein zweites thermisches Grenzflächenmaterial (224-2, 324-2); und
ein Auskleidungsmaterial (222, 322), wobei das erste thermische Grenzflächenmaterial (224-1, 324-1) durch das Auskleidungsmaterial (222, 322) mit dem zweiten thermischen Grenzflächenmaterial (224-2, 324-2) gekoppelt ist;
**dadurch gekennzeichnet, dass**
das Auskleidungsmaterial (222, 322) ein relativ dünnes Polymermaterial ist, so dass das Speicher-Kühlpad (120, 220, 320, 420) um eine Speichereinheit gefaltet werden kann, so dass sich das erste thermische Grenzflächenmaterial (224-1, 324-1) auf einer ersten Seite der Speichereinheit und das zweite thermische Grenzflächenmaterial (224-2, 324-2) auf einer zweiten Seite der Speichereinheit befindet.

2. Speicher-Kühlpad (120, 220, 320, 420) nach Anspruch 1, das einen Raum zwischen dem ersten thermischen Grenzflächenmaterial (224-1, 324-1) und dem zweiten thermischen Grenzflächenmaterial (224-2, 324-2) umfasst.

3. Speicher-Kühlpad (120, 220, 320, 420) nach Anspruch 2, wobei der Raum zwischen der ersten Seite der Speichereinheit und der zweiten Seite der Speichereinheit angeordnet ist.

4. Speicher-Kühlpad (120, 220, 320, 420) nach Anspruch 3, wobei sich das Auskleidungsmaterial (222, 322) von dem ersten thermischen Grenzflächenmaterial (224-1, 324-1) und dem zweiten thermischen Grenzflächenmaterial (224-2, 324-2) unterscheidet.

5. Speicher-Kühlpad (120, 220, 320, 420) nach Anspruch 3, wobei der Abstand zwischen 4 Millimeter und 6 Millimeter beträgt.

6. Speicher-Kühlpad (120, 220, 320, 420) nach Anspruch 3, wobei der Raum so konfiguriert ist, dass er einen Nicht-Grenzflächenbereich bildet.

7. Speicher-Kühlpad (120, 220, 320, 420) nach Anspruch 1, wobei das erste thermische Grenzflächenmaterial (224-1, 324-1) und das zweite thermische Grenzflächenmaterial (224-2, 324-2) eine mit dem Auskleidungsmaterial (222, 322) gekoppelte Außenseite und eine nicht mit dem Auskleidungsmaterial (222, 322) gekoppelte Innenseite aufweisen.

8. Speicher-Kühlpad (120, 220, 320, 420) nach Anspruch 7, wobei die Innenseite des ersten thermischen Grenzflächenmaterials (224-1, 324-1) und des zweiten thermischen Grenzflächenmaterials (224-2, 324-2) ein nichtklebendes Material umfasst.

9. Speicher-Kühlpad (120, 220, 320, 420) nach Anspruch 2, wobei der Raum ein Grenzbereich zwischen der Speichervorrichtung und der Kühlanordnung ist.

10. Speicher-Kühlpad (120, 220, 320, 420) nach Anspruch 1, wobei das erste thermische Grenzflächenmaterial (224-1, 324-1) und das zweite thermische Grenzflächenmaterial (224-2, 324-2) relativ anpassbare Materialien sind.

11. System, das das Speicher-Kühlpad (120, 220, 320, 420) nach Anspruch 1 umfasst, wobei dasselbe ferner Folgendes umfasst:
eine Kühlanordnung, die Kammstrukturen umfasst, wobei das Speicher-Kühlpad durch die zwischen der Speichereinheit (120, 220, 320, 420) und einer anderen Speichereinheit angeordneten Kammstrukturen der Kühlanordnung zusammengedrückt wird.

12. System nach Anspruch 1, wobei das erste thermische Grenzflächenmaterial (224-1, 324-1) und das zweite thermische Grenzflächenmaterial (224-2, 324-2) ein Material umfassen, das elektrisch isolierend und thermisch leitend ist.

## Revendications

1. Tampon de refroidissement de mémoire (120, 220, 320, 420), comprenant :
un premier matériau d'interface thermique (224-1, 324-1) ;
un second matériau d'interface thermique (224-2, 324-2) ; et
un matériau de revêtement (222, 322) par lequel le premier matériau d'interface thermique (224-1, 324-1) est accouplé au second matériau d'interface thermique (224-2, 324-2) par le matériau de revêtement (222, 322) ;
**caractérisé en ce que** le matériau de revêtement (222, 322) est un matériau polymère relativement mince de sorte que le tampon de refroidissement de mémoire (120, 220, 320, 420) peut être plié autour d'une unité de mémoire de sorte que le premier matériau d'interface thermique (224-1, 324-1) est sur un premier côté de l'unité de mémoire et que le second matériau d'interface thermique (224-2, 324-2) est sur un second côté de l'unité de mémoire.

2. Tampon de refroidissement de mémoire (120, 220, 320, 420) selon la revendication 1, comprenant un espace entre le premier matériau d'interface thermique (224-1, 324-1) et le second matériau d'interface thermique (224-2, 324-2).

3. Tampon de refroidissement de mémoire (120, 220, 320, 420) selon la revendication 2, dans lequel l'espace est positionné entre le premier côté de l'unité de mémoire et le second côté de l'unité de mémoire.

4. Tampon de refroidissement de mémoire (120, 220, 320, 420) selon la revendication 3, dans lequel le matériau de revêtement (222, 322) est différent du premier matériau d'interface thermique (224-1, 324-1) et du second matériau d'interface thermique (224-2, 324-2).

5. Tampon de refroidissement de mémoire (120, 220, 320, 420) selon la revendication 3, dans lequel l'espace est compris entre 4 millimètres et 6 millimètres.

6. Tampon de refroidissement de mémoire (120, 220, 320, 420) selon la revendication 3, dans lequel l'espace est conçu pour fournir une zone sans interface.

7. Tampon de refroidissement de mémoire (120, 220, 320, 420) selon la revendication 1, dans lequel le premier matériau d'interface thermique (224-1, 324-1) et le second matériau d'interface thermique (224-2, 324-2) comprennent un côté extérieur accouplé au matériau de revêtement (222, 322) et un côté intérieur non accouplé au matériau de revêtement (222, 322).

8. Tampon de refroidissement de mémoire (120, 220, 320, 420) selon la revendication 7, dans lequel le côté intérieur du premier matériau d'interface thermique (224-1, 324-1) et du second matériau d'interface thermique (224-2, 324-2) comprend un matériau non adhésif.

9. Tampon de refroidissement de mémoire (120, 220, 320, 420) selon la revendication 2, dans lequel l'espace est une interface entre le dispositif de mémoire et l'ensemble de refroidissement.

10. Tampon de refroidissement de mémoire (120, 220, 320, 420) selon la revendication 1, dans lequel le premier matériau d'interface thermique (224-1, 324-1) et le second matériau d'interface thermique (224-2, 324-2) sont des matériaux relativement adaptables.

11. Système comprenant le coussin de refroidissement de mémoire (120, 220, 320, 420) selon la revendication 1, comprenant en outre :
un ensemble de refroidissement comprenant des structures en peigne, dans lequel le coussin de refroidissement est comprimé par les structures en peigne de l'ensemble de refroidissement positionné entre l'unité de mémoire (120, 220, 320, 420) et une unité de mémoire différente.

12. Système selon la revendication 1, dans lequel le premier matériau d'interaction thermique (224-1, 324-1) et le second matériau d'interface thermique (224-2, 324-2) comprennent un matériau qui est électriquement isolant et thermiquement conducteur.
